# FASCICULE DE BREVET EUROPEEN

(11) **EP 2 474 214 B1**
(45) Date de publication et mention de la délivrance du brevet: **11.11.2015**
(21) Numéro de dépôt: 10751649.4
(22) Date de dépôt: 02.09.2010
(51) Int. Cl.: H05K 5/06, H05K 5/02

(54) **TRAVERSÉE D'UNE PAROI D'UN BOÎTIER**
BUCHSE FÜR EINE GEHÄUSEWAND
BUSHING FOR A WALL OF A CASING

(30) Priorité: 04.09.2009 FR 0904214
(43) Date de publication de la demande: 11.07.2012
(73) Titulaire: Thales, 92200 Neuilly Sur Seine (FR)
(72) Inventeur: DREVON, Claude, 31500 Toulouse (FR); VENDIER, Olivier, 31120 Lacroix-Falgarde (FR); NEVO, David, 31300 Toulouse (FR)
(74) Mandataire: Esselin, Sophie
(86) Numéro de dépôt international: PCT/EP2010/062857
(87) Numéro de publication internationale: WO 2011/026889

(56) Documents cités:
- WO-A1-2005/088709
- DE-A1-102005 063 280
- FR-A1- 2 423 955

## Description

L'invention concerne le domaine des boîtiers de puissance et plus particulièrement des traversées pratiquées dans ces boîtiers.

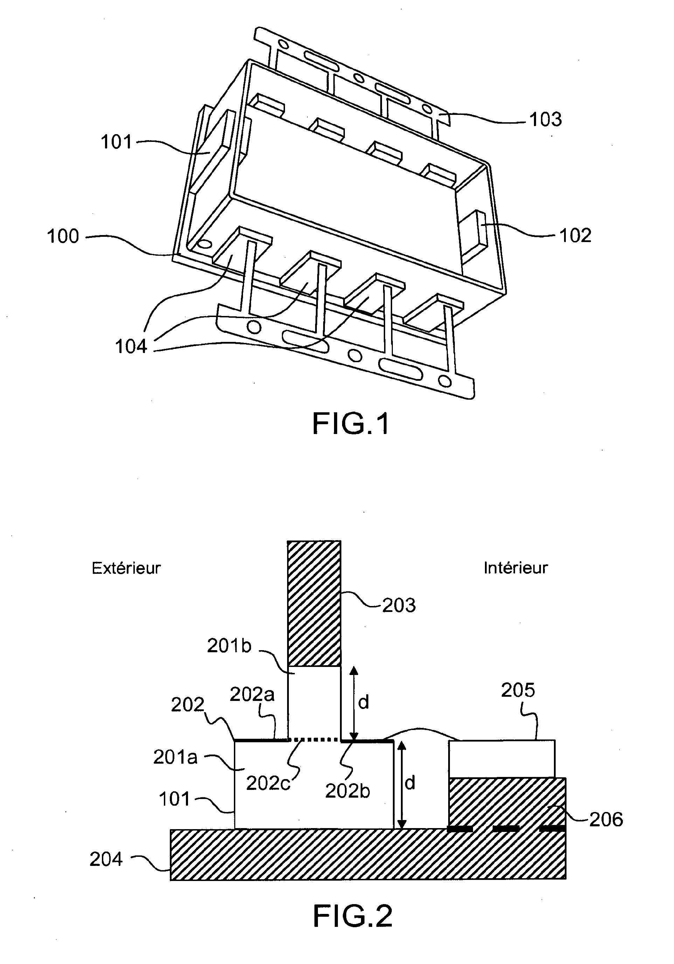

La figure 1 représente un boîtier de puissance hermétique.

Un tel boîtier comprend un socle 100 métallique sur lequel est disposé un mur métallique comportant quatre parois. Deux traversées hermétiques 101 et 102, situées chacune sur deux parois opposées, permettent l'entrée et la sortie d'une ligne signal (non représentée) principalement hyperfréquence.

Des traversées hermétiques 104 permettent d'acheminer des signaux basses fréquences, comme des alimentations ou des commandes. Une grille métallique 103 permet de connecter ensemble, pendant la phase d'assemblage des différents composants, ces différents signaux pour éviter les décharges électrostatiques.

Ce type de microboîtier est utilisé pour réaliser des fonctions électroniques à base de puces nues telles que des amplificateurs de forte puissance dans le domaine des hyperfréquences et microondes, voir WO 2005/088709 A1.

La figure 2 représente une vue en coupe d'une traversée hermétique selon l'état de la technique. La traversée 101, réalisée dans un matériau isolant type céramique, permet le passage d'une ligne signal 202 au travers d'une paroi 203 d'un boîtier. La traversée repose sur le socle 204 du boîtier. La ligne signal comporte une première partie 202a à l'extérieur du boîtier, une deuxième partie 202b à l'intérieur du boîtier et une troisième partie 202c enfouie au niveau de la traversée. La ligne signal est reliée à des composants 205 situés à l'intérieur du boîtier. Un piédestal 206 placé entre le socle 204 et les composants 205 permet de disposer les composants au même niveau que la ligne signal 202 et limiter les désadaptations hyperfréquences dues à la longueur du fil de connexion.

La traversée céramique multicouches comporte : une première couche 201 a en contact avec le socle 204 du boîtier à la surface de laquelle est disposée une ligne signal 202 et une deuxième couche 201 b recouvrant la première couche 201 a au niveau de la paroi 203.

Un des problèmes majeurs de l'utilisation des boîtiers de puissance dans le vide est l'existence d'un phénomène appelé effet multipactor qui peut survenir au niveau des traversées hermétiques. L'effet multipactor est un phénomène parasite dans les dispositifs où l'on transmet une onde hyperfréquence sous vide. On le rencontre en particulier dans les tubes à vide, les structures pour accélérateur de particules et les circuits micro-ondes à bord des satellites. Le mécanisme de base du multipactor est le suivant : des électrons primaires accélérés par le champ hyperfréquence bombardent une surface, ce qui entraîne l'émission d'électrons secondaires qui sont à leur tour accélérés par le champ hyperfréquence et viennent bombarder une surface et causer l'émission d'autres électrons secondaires. Pour une géométrie donnée et certaines valeurs de fréquence et d'amplitude du champ, les conditions sont réunies pour une croissance exponentielle du nombre d'électrons en transit. On se trouve alors dans les conditions de la décharge multipactor. La croissance du nombre d'électrons en transit est limitée par un phénomène de saturation, et la décharge peut évoluer au cours du temps.

Le multipactor est le plus souvent un phénomène gênant : le champ hyperfréquence cède de l'énergie pour accélérer les électrons et l'énergie ainsi acquise par les électrons est essentiellement transformée en chaleur lors de l'impact (l'énergie des secondaires émis est faible). On a donc à la fois une perte de l'énergie transmise ou stockée dans la structure hyperfréquence et un échauffement de celle-ci.

Ce phénomène de décharge survient dans les boîtiers entre la partie extérieure au boîtier de la ligne signal d'une part et l'enceinte métallique du boîtier d'autre part. Il a pour conséquence de détruire la ligne signal. La partie interne des boîtiers hermétiques de la ligne signal n'est pas concernée car le boîtier contient alors un gaz. Dans le cas des boîtiers non hermétiques, la partie interne au boîtier de la ligne signal est aussi concernée par le multipactor. La façon la plus simple de prévenir ce phénomène consiste à éloigner suffisamment la ligne signal externe des autres éléments conducteurs. Pour ce faire on calcule une distance de sécurité d minimale qui permet d'éviter le multipactor. Cette distance est dépendante de la puissance du signal. Typiquement pour un signal d'une puissance de 40 W la distance de sécurité est de 2 mm pour une marge de 6dB et de 2,5 mm pour une marge de 10dB. La marge permet de s'affranchir de l'incertitude des simulations électromagnétiques et des tolérances de fabrication. Selon des normes en vigueur la marge de 6dB est considérée comme suffisante pour garantir l'absence totale de multipactor mais un test électrique est nécessaire pour confirmer l'absence de multipactor. La marge de 10dB est suffisante pour s'affranchir du test électrique.

La hauteur de la première couche 201 a de la traversée est donc au minimum égale à cette distance de sécurité d pour prévenir un multipactor entre la ligne 202 et le socle 204 du boîtier. La hauteur de la deuxième couche 201 b est au minimum égale à la distance d de sécurité pour prévenir un multipactor entre la ligne 202 et la paroi 203 du boîtier. La hauteur de la traversée est donc au minimum de deux fois la distance de sécurité d. Typiquement, pour une puissance à transmettre de 40 W, la traversée a une hauteur totale de 5 mm pour une marge de 10 dB. Cette distance d est également applicable dans le plan horizontal entre la ligne 202a et la paroi métallique.

Un problème survient lorsqu'on souhaite transmettre plus de puissance dans les lignes. Par exemple, pour une puissance de 150 W la distance de sécurité d devient de 5 mm avec une marge de 10dB. Cette distance implique une augmentation de la hauteur des traversées hermétiques. Selon l'état de la technique, on atteint une limite de fabricabilité pour une hauteur de traversée céramique autour de 6 mm. Autrement dit, il est très difficile de fabriquer une traversée d'une hauteur de 10mm.

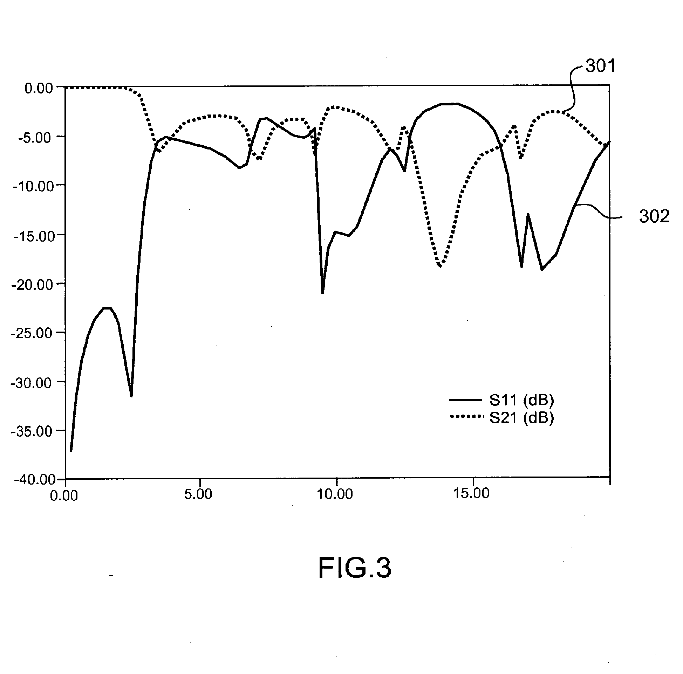

De plus, l'augmentation de la hauteur du substrat dans lequel est réalisée la traversée entraîne des problèmes électriques difficiles à résoudre. La figure 3 illustre une courbe de variation du coefficient de réflexion du signal à l'entrée / sortie 302 d'une traversée de 10mm de hauteur et une courbe de perte de puissance 301 associée. L'unité en ordonnée est le décibel, l'unité en abscisse est le gigahertz. En observant la courbe de réponse, on constate la présence d'une fréquence de coupure en dessous de laquelle la perte de puissance du signal transmis est négligeable et au-delà de laquelle la perte de puissance augmente brusquement. Au-delà de cette fréquence la traversée n'est pas utilisable. Ce phénomène est dû au fait que l'onde ne se propage plus dans la ligne signal qui se met à rayonner comme une antenne. Pour une traversée de hauteur 10 mm, la fréquence de coupure se situe autour de 2 gigahertz. La traversée n'est donc pas utilisable avec un signal d'une fréquence de 3 gigahertz.

En résumé, une telle traversée présente les inconvénients suivants : tout d'abord, cette traversée est très difficile à fabriquer ; de plus elle comporte une limitation électrique (pour les fréquences supérieures à 2 gigahertz); et enfin la hauteur totale du boîtier sans piédestal est rédhibitoire et incompatible avec des moyens de fabrication connus.

Une autre solution consiste à recouvrir de peinture isolante les parties métalliques reliées à la masse (paroi du boîtier et socle). Cependant, il existe un risque de délaminage. De plus l'application de cette peinture est délicate à mettre en oeuvre.

Une autre alternative est de recouvrir la ligne signal externe d'une résine (glob-top). Mais il existe un risque de fissures, de délaminage en cyclages thermiques et de modification de la réponse électrique due à la présence d'une résine sur la ligne 202a, cette résine présentant une constante diélectrique significative.

L'invention vise à pallier les problèmes cités précédemment en proposant une traversée minimisant les risques d'apparition d'effets multipactor et fonctionnant à des puissances élevées.

A cet effet, l'invention a pour objet un dispositif pour l'acheminement d'un signal selon la revendication 1.

En utilisant l'invention, comme il n'est pas nécessaire d'augmenter la hauteur de la traversée pour faire passer plus de puissance, des lignes signal adaptées à 50 Ohms peuvent donc être de largeur plus réduite. Par conséquent, la traversée et ses lignes signal associées présentent une meilleure réponse pour les fréquences les plus hautes.

Selon une première variante de l'invention, la première et la deuxième portion de ligne signal sont décalées en hauteur, ladite hauteur étant considérée parallèle à la paroi.

Un avantage de la première variante de l'invention provient de son aspect dissymétrique. La hauteur de la première couche peut être inférieure à la distance de sécurité. Ainsi la hauteur de la ligne signal à l'intérieur du boîtier se trouve abaissée. Il est donc possible de réduire ou même de supprimer le piédestal à l'intérieur du boîtier.

L'invention permet d'utiliser des traversées céramiques de moindre hauteur. Ceci limite également la hauteur du mur dans lequel est disposée la traversée. Le facteur de forme du boîtier (ratio entre la largeur et la longueur d'une part et la hauteur du mur métallique d'autre part) est donc réduit. Ceci entraine des contraintes (en particulier thermomécaniques) moindres, à la fois pendant la fabrication du boîtier (brasage haute température du socle 100, du mur métallique 203 et des traversées 101, 102 et 104) et après fermeture hermétique du boîtier.

L'invention sera mieux comprise et d'autres avantages apparaîtront à la lecture de la description détaillée faite à titre d'exemple non limitatif et à l'aide des figures parmi lesquelles :
La figure 1, déjà présentée, représente un boîtier de puissance hermétique.
La figure 2, déjà présentée, représente une vue en coupe d'une traversée hermétique selon l'état de la technique.
La figure 3, déjà présentée, illustre une courbe de réponse d'une traversée selon l'art connu.
La figure 4 représente une vue en coupe d'une première variante de réalisation d'une traversée selon l'invention.
La figure 5 illustre une courbe de réponse d'une traversée selon l'invention.
La figure 6 représente une vue en coupe d'une seconde variante de réalisation d'une traversée selon l'invention.

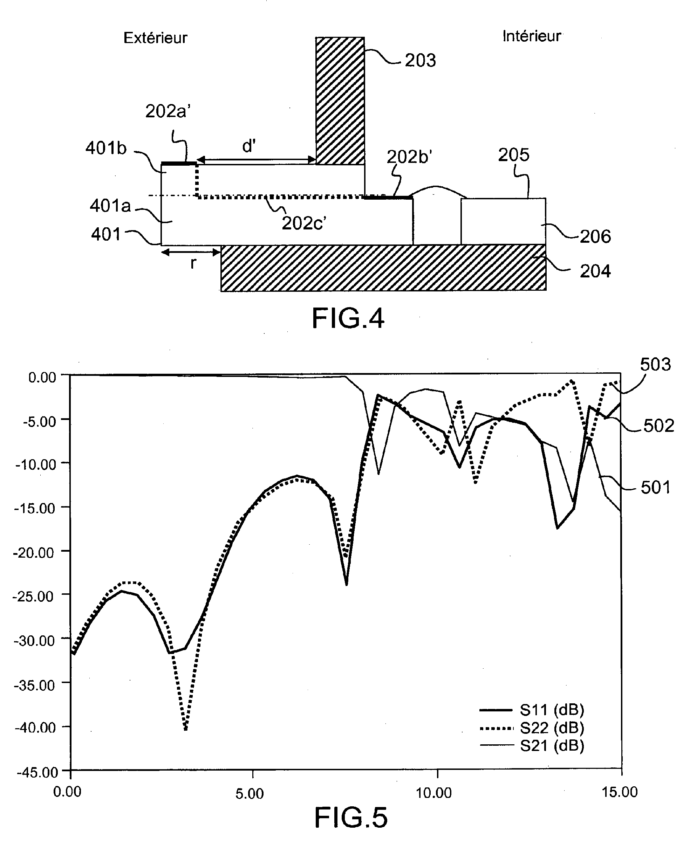

La figure 4 représente une vue en coupe d'une première variante d'une traversée selon l'invention. La traversée d'une paroi 203 d'un boîtier de puissance permet le passage d'une ligne signal. Le boîtier comporte un socle 204. La paroi 203 délimite une partie intérieure et une partie extérieure. La traversée comporte une première portion 202a' de ligne signal à l'extérieur du boîtier, une deuxième portion 202b' de ligne signal à l'intérieur du boîtier et une troisième portion 202c' de ligne signal reliant les deux autres portions 202a', 202b'. La première portion 202a' est décalée de la paroi de façon à respecter une première distance de sécurité prédéterminée avec la paroi. La troisième portion 202c' est enterrée sur toute sa longueur.

La troisième portion 202c' de ligne signal est décalée en hauteur par rapport à la première portion de ligne signal 202a'.

La première distance de sécurité vise à prévenir un effet multipactor à l'extérieur du boîtier.

En pratique, la traversée multicouche comporte une première couche 401 a en contact avec le socle 204 du boîtier. La première couche est un bloc de forme parallélépipédique. La troisième portion de ligne signal 202c' est disposée sur la surface de la première couche 401 a.

La traversée comporte une deuxième couche 401 b recouvrant la première couche 401a au niveau de la partie extérieure au boîtier et au niveau de la paroi 203 du boîtier. La deuxième couche est un bloc de forme parallélépipédique dans le volume duquel traverse un trou métallisé. Ce trou métallisé relie la troisième portion 202c' de la ligne signal (située au contact de la face inférieure de la deuxième couche) à la première portion de ligne signal 202a' située sur la face supérieure de la deuxième couche 401 b.

Selon la première variante de l'invention, la première 202a' et la deuxième 202b' portion de ligne signal sont décalées en hauteur, ladite hauteur étant considérée parallèle à la paroi 203. En mettant en oeuvre cette variante de l'invention, il est possible de réduire la hauteur de la première couche et donc de réduire voire de supprimer le piédestal 206 supportant les composants 205 auxquels est reliée la ligne signal.

La première portion de ligne signal 202a' est suffisamment éloignée pour que la distance de sécurité prédéterminée soit respectée. Par exemple, pour une distance de sécurité d' de 5mm avec la paroi, la première portion de ligne signal 202a' est décalée d'une distance 5mm.

A l'extérieur du boîtier, la première portion de ligne signal 202a' est disposée sur la deuxième couche 401 b. Un trou métallisé réalisé dans cette deuxième couche 401 b permet d'amener le signal au niveau de l'interface entre les couches 401 b et 401 a. En surface de la couche 401 a, la troisième portion 202c' de ligne signal est enterrée. La deuxième portion de ligne signal 202b'est accessible en partie intérieure pour câbler le composant associé.

Les différentes lignes sont réalisées par sérigraphie de pates conductrices. Sur les parties de ligne signal externes 202a' et 202c', une finition type nickel-or est appliquée.

La troisième portion 202c' de la ligne signal est enterrée. L'effet multipactor n'intervenant que dans le vide, cette portion de ligne ne peut donc pas y être soumise. La distance de sécurité d à considérer est la distance entre la première portion de ligne signal 202a' à la surface de la deuxième couche et les parties métalliques du boîtier : la paroi d'une part et le socle d'autre part.

La ligne signal 202c' est enterrée dans la traversée à l'extérieur du boîtier. Cela permet d'éloigner la ligne dans le vide d'un plan de masse sans augmenter la hauteur de la traversée.

Un des avantages de l'invention est de présenter de meilleures performances lorsqu'elle est utilisée avec des signaux hautes fréquences. La figure 5 illustre une courbe de réponse d'une traversée selon l'invention. La courbe 501 représente les pertes de puissance entre l'entrée et la sortie de la traversée. Les courbes 502 et 503 correspondant aux paramètres de réflexion respectivement en entrée et en sortie. Il s'agit d'une traversée d'une hauteur de 4mm utilisée avec un signal de 150W. Comme pour la figure 3, les courbes de la figure 5 sont exprimées en décibel en fonction de la fréquence. On constate que la perte brutale de puissance n'intervient non pas à 2 gigahertz comme pour la traversée selon l'art connu mais aux alentours de 7.5 gigahertz.

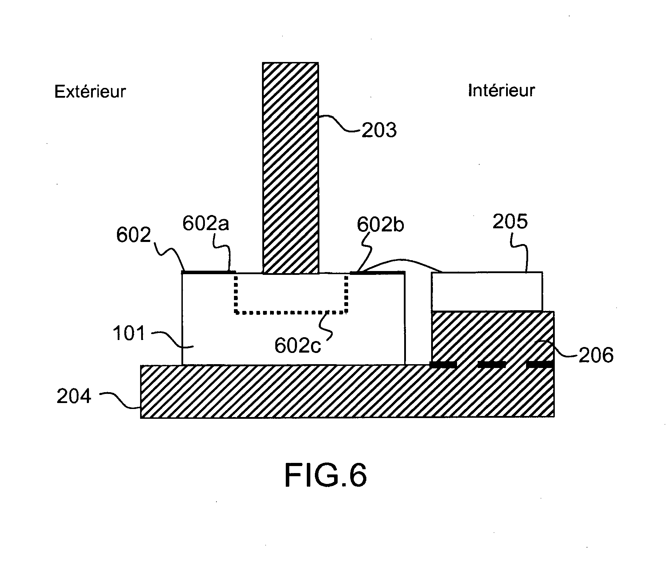

Selon une seconde variante de l'invention, la deuxième 202b' portion de ligne signal est décalée de la paroi de façon à respecter une seconde distance de sécurité prédéterminée. La figure 6 représente une vue en coupe d'une seconde variante de réalisation d'une traversée hermétique selon l'invention. Comme pour la première variante, la traversée hermétique comporte une première portion 602a de ligne signal à l'extérieur du boîtier, une deuxième portion 602b de ligne signal à l'intérieur du boîtier et une troisième portion 602c de ligne signal reliant les deux autres portions 602a, 602b. La première portion 602a est décalée de la paroi de façon à respecter une première distance de sécurité prédéterminée avec la paroi. La troisième portion 602c est enterrée sur toute sa longueur. Néanmoins, comme la première portion 602a et la deuxième portion 602b ne sont pas décalées en hauteur, il peut être alors nécessaire d'utiliser un piédestal 206 à l'intérieur du boîtier.

Dans le cas où le boîtier est un boîtier hermétique, la seconde distance de sécurité vise à prévenir un effet corona à l'intérieur du boîtier.

L'effet Corona apparait lors de la baisse de pression interne du boîtier utilisé en orbite compte tenu du taux de fuite du boîtier déterminé au sol. Il n'existe pas de norme pour s'en prémunir sauf à éloigner la ligne signal de tout plan de masse afin de diminuer le champ électrique qui induit la décharge ou d'enterrer les conducteur dans un diélectrique de protection pour que le plasma ne se forme qu'à très fort niveau. L'effet Corona est une décharge se produisant lorsqu'un courant, continu ou non, se crée entre deux électrodes portées à un haut potentiel et séparées par un fluide neutre, en général l'air, par ionisation de ce fluide. Un plasma est alors créé et les charges électriques se propagent en passant des ions aux molécules de gaz neutres. Lorsque le champ électrique en un point du fluide est suffisamment grand, le fluide s'ionise autour de ce point et devient conducteur. Si la géométrie du conducteur et la valeur du champ sont telles que la région ionisée s'étende au lieu de se stabiliser, le courant peut finir par trouver un chemin jusqu'à l'électrode inverse, il se forme alors des étincelles ou un arc électrique qui viendra détruire la structure.

Dans le cas où le boîtier est un boîtier non hermétique, la seconde distance de sécurité vise à prévenir un effet multipactor à l'intérieur du boîtier. Si le boîtier n'est plus hermétique, l'intérieur du boîtier est aussi sous vide. Dans ces conditions, la ligne signal peut aussi être soumise à un effet multipactor. Dans ce cas la traversée sera symétrique.

Selon une variante de l'invention, la traversée est réalisée dans un matériau isolant hermétique et obtenu par frittage haute température comme par exemple les céramiques principalement composées de poudre d'alumine, de liants et plastifiants, et autres additifs. Le matériau isolant hermétique peut être utilisé aussi bien sur des boîtiers hermétiques que sur des boîtiers non hermétiques.

Selon une autre variante de l'invention, la traversée est réalisée dans un matériau organique. Ce type de matériau peut être par exemple une base epoxy à trame de verre ou trame de quartz. L'utilisation d'un matériau organique pour réaliser cette transition rend par essence le boitier complet non hermétique.

Avantageusement, la traversée est disposée sur le socle de façon à former un retrait r par rapport au socle. Ceci a pour effet d'allonger la distance entre le socle et la partie externe de la ligne signal. Il est possible ainsi d'utiliser une première couche dont la hauteur est inférieure à la première distance de sécurité. Ceci peut permettre de supprimer le piédestal à l'intérieur du boîtier. La longueur du retrait r est par exemple de 1 mm. Les hauteurs des première et deuxième couches 401 a et 401 b sont alors de respectivement de 1 mm et 3mm.

Avantageusement, la traversée comporte en outre une résine recouvrant la première portion 202a' de ligne signal. La résine est disposée sur la zone de câblage 202a' et le fil de connexion associé. La résine étant isolante par nature, ceci augmente la distance d entre la masse métallique du boîtier et la ligne hyperfréquence active.

Avantageusement, la traversée comporte en outre une résine recouvrant la deuxième portion 202b' de ligne signal.

## Revendications

1. Dispositif hermétique pour l'acheminement d'un signal au travers d'une paroi (203) d'un boîtier de puissance comportant un socle (204), une première couche (201 a) en contact avec le socle (204) du boîtier et une deuxième couche (201 b) recouvrant la première couche (201 a) au niveau de la paroi (203), la première couche étant disposée sur le socle (204) au contact de la paroi (203), la paroi (203) délimitant une partie intérieure et une partie extérieure, ledit dispositif hermétique comportant une première portion (202a') de ligne signal à l'extérieur du boîtier, une deuxième portion (202b') de ligne signal à l'intérieur du boîtier et une troisième portion (202c') de ligne signal reliant les deux autres portions (202a', 202b'), ledit dispositif étant **caractérisé en ce que** la première portion (202a') est décalée de la paroi (203) de façon à respecter une première distance de sécurité prédéterminée et **en ce que** la troisième portion (202c') est enterrée dans le dispositif sur toute sa longueur et disposée sur la surface de la première couche.

2. Dispositif pour l'acheminement d'un signal selon la revendication 1, **caractérisée en ce que** la première (202a') et la deuxième (202b') portion de ligne signal sont décalées en hauteur, ladite hauteur étant considérée parallèle à la paroi (203).

3. Dispositif pour l'acheminement d'un signal selon la revendication 1, **caractérisée en ce que** la deuxième (202b') portion de ligne signal est décalée de la paroi de façon à respecter une seconde distance de sécurité prédéterminée.

4. Dispositif pour l'acheminement d'un signal selon l'une des revendications 1 à 3, **caractérisée en ce que** le boîtier est hermétique et **en ce que** la seconde distance de sécurité vise à prévenir un effet corona à l'intérieur du boîtier.

5. Dispositif pour l'acheminement d'un signal selon l'une des revendications 1 à 3, **caractérisée en ce que** le boîtier n'est pas hermétique et **en ce que** la seconde distance de sécurité vise à prévenir un effet multipactor à l'intérieur du boîtier.

6. Dispositif pour l'acheminement d'un signal selon l'une des revendications précédentes, **caractérisée en ce qu'**elle est réalisée dans un matériau isolant hermétique et obtenu par frittage haute température.

7. Dispositif pour l'acheminement d'un signal selon la revendication 5, **caractérisée en ce qu'**elle est réalisée dans un matériau organique.

8. Dispositif pour l'acheminement d'un signal selon l'une des revendications précédentes, **caractérisée en ce que** la traversée est disposée sur le socle (204) de façon à former un retrait (r) par rapport au socle (204).

9. Dispositif pour l'acheminement d'un signal selon l'une des revendications précédentes, **caractérisée en ce qu'**elle comporte en outre une résine recouvrant la première portion (202a') de ligne signal.

10. Dispositif pour l'acheminement d'un signal selon l'une des revendications précédentes, **caractérisée en ce qu'**elle comporte en outre une résine recouvrant la deuxième portion (202b') de ligne signal.

## Patentansprüche

1. Hermetische Vorrichtung zum Leiten eines Signals durch eine Wand (203) eines Leistungsgehäuses, umfassend einen Sockel (204), eine erste Schicht (201a) in Kontakt mit dem Sockel (204) des Gehäuses und eine zweite Schicht (201b), die die erste Schicht (201a) an der Wand (203) bedeckt, wobei die erste Schicht auf dem Sockel (204) in Kontakt mit der Wand (203) angeordnet ist, wobei die Wand (203) einen inneren Teil und einen äußeren Teil begrenzt, wobei die hermetische Vorrichtung einen ersten Signalleitungsabschnitt (202a') auf der Außenseite des Gehäuses, einen zweiten Signalleitungsabschnitt (202b') auf der Innenseite des Gehäuses und einen dritten Signalleitungsabschnitt (202c') aufweist, der die beiden anderen Abschnitte (202a', 202b') verbindet, wobei die Vorrichtung **dadurch gekennzeichnet ist, dass** der erste Abschnitt (202a') von der Wand (203) so versetzt ist, dass ein vorbestimmter erster Sicherheitsabstand eingehalten wird, und dadurch, dass der dritte Abschnitt (202c') über seine gesamte Länge in der Vorrichtung eingebettet und auf der Oberfläche der ersten Schicht angeordnet ist.

2. Vorrichtung zum Leiten eines Signals nach Anspruch 1, **dadurch gekennzeichnet, dass** der erste (202a') und der zweite (202b') Signalleitungsabschnitt höhenmäßig voneinander versetzt sind, wobei die Höhe parallel zu der Wand (203) betrachtet wird.

3. Vorrichtung zum Leiten eines Signals nach Anspruch 1, **dadurch gekennzeichnet, dass** der zweite Signalleitungsabschnitt (202b') von der Wand so versetzt ist, dass ein vorbestimmter zweiter Sicherheitsabstand eingehalten wird.

4. Vorrichtung zum Leiten eines Signals nach einem der Ansprüche 1 bis 3, **dadurch gekennzeichnet, dass** das Gehäuse hermetisch ist, und dadurch, dass der zweite Sicherheitsabstand einen Koronaeffekt im Innern des Gehäuses verhüten soll.

5. Vorrichtung zum Leiten eines Signals nach einem der Ansprüche 1 bis 3, **dadurch gekennzeichnet, dass** das Gehäuse nicht hermetisch ist, und dadurch, dass der zweite Sicherheitsabstand einen Multipaktor-Effekt im Innern des Gehäuses verhüten soll.

6. Vorrichtung zum Leiten eines Signals nach einem der vorherigen Ansprüche, **dadurch gekennzeichnet, dass** sie aus einem hermetischen Isoliermaterial gefertigt und durch Hochtemperatursintern erhalten wird.

7. Vorrichtung zum Leiten eines Signals nach Anspruch 5, **dadurch gekennzeichnet, dass** sie aus einem organischen Material hergestellt ist.

8. Vorrichtung zum Leiten eines Signals nach einem der vorherigen Ansprüche, **dadurch gekennzeichnet, dass** die Passage so auf dem Sockel (204) angeordnet ist, dass ein Absatz (r) in Bezug auf den Sockel (204) gebildet wird.

9. Vorrichtung zum Leiten eines Signals nach einem der vorherigen Ansprüche, **dadurch gekennzeichnet, dass** sie ferner ein Harz umfasst, das den ersten Signalleitungsabschnitt (202a') bedeckt.

10. Vorrichtung zum Leiten eines Signals nach einem der vorherigen Ansprüche, **dadurch gekennzeichnet, dass** sie ferner ein Harz umfasst, das den zweiten Signalleitungsabschnitt (202b') bedeckt.

## Claims

1. A hermetic device for transferring a signal through a wall (203) of a power package comprising a base (204), a first layer (201a) in contact with the base (204) of the package and a second layer (201b) covering the first layer (201a) at the wall (203), the first layer being placed on the base (204) in contact with the wall (203), the wall (203) bounding an internal part and an external part, said hermetic device comprising a first signal line portion (202a') outside the package, a second signal line portion (202b') inside the package and a third signal line portion (202c') connecting the other two portions (202a', 202b'), said device being **characterized in that** the first portion (202a') is shifted from the wall (203) so as to respect a first predefined safety distance and **in that** the third portion (202c') is buried in the device over its entire length and placed on the surface of the first layer.

2. The signal-transfer device as claimed in claim 1, **characterized in that** the first (202a') and second (202b') signal line portions are shifted in height, said height being considered parallel to the wall (203).

3. The signal-transfer device as claimed in claim 1, **characterized in that** the second signal line portion (202b') is shifted from the wall so as to respect a second predefined safety distance.

4. The signal-transfer device as claimed in one of claims 1 to 3, **characterized in that** the package is hermetic and **in that** the second safety distance is intended to prevent corona forming inside the package.

5. The signal-transfer device as claimed in one of claims 1 to 3, **characterized in that** the package is not hermetic and **in that** the second safety distance is intended to prevent multipacting inside the package.

6. The signal-transfer device as claimed in any one of the previous claims, **characterized in that** it is made of a hermetic insulating material and obtained by high-temperature sintering.

7. The signal-transfer device as claimed in claim 5, **characterized in that** it is made of an organic material.

8. The signal-transfer device as claimed in any one of the preceding claims, **characterized in that** the feedthrough is placed on the base (204) so as to form a recess (r) relative to the base (204).

9. The signal-transfer device as claimed in any one of the preceding claims, **characterized in that** it furthermore comprises a resin covering the first signal line portion (202a').

10. The signal-transfer device as claimed in any one of the preceding claims, **characterized in that** it furthermore comprises a resin covering the second signal line portion (202b').
